# EUROPEAN PATENT SPECIFICATION

(11) **EP 2 038 670 B1**
(45) Date of publication and mention of the grant of the patent: **17.11.2010**
(21) Application number: 07789712.2
(22) Date of filing: 18.06.2007
(51) Int. Cl.: G01R 33/09, G01R 33/12, G01N 15/06

(54) **MAGNETIC SENSOR DEVICE WITH FIELD GENERATORS AND SENSOR ELEMENTS**
MAGNETSENSORVORRICHTUNG MIT FELDGENERATOREN UND SENSORELEMENTEN
DISPOSITIF DE DÉTECTEUR MAGNÉTIQUE AVEC DES GÉNÉRATEURS DE CHAMP ET DES ÉLÉMENTS DÉTECTEURS

(30) Priority: 28.06.2006 EP 06116180
(43) Date of publication of application: 25.03.2009
(73) Proprietor: Koninklijke Philips Electronics N.V., 5621 BA Eindhoven (NL)
(72) Inventor: NIEUWENHUIS, Jeroen Hans, 5656 AA Eindhoven (NL); ZON, Hans, 5656 AA Eindhoven (NL); KAHLMAN, Johannes Arnoldus Henricus Maria, 5656 AA Eindhoven (NL)
(74) Representative: Van Velzen, Maaike Mathilde
(86) International application number: PCT/IB2007/052327
(87) International publication number: WO 2008/001263

(56) References cited:
- WO-A-2005/010542
- WO-A-2005/010543
- US-B1- 6 181 535
- US-B1- 6 194 896

## Description

The invention relates to a method and a magnetic sensor device for the detection of magnetized particles in an investigation region with a magnetic field generator and a magnetic sensor element that are driven by an excitation current and a sensor current, respectively. Moreover, it relates to the use of such a magnetic sensor device.

From the WO 2005/010543 A1 and WO 2005/010542 A2 (which are incorporated into the present application by reference) a microelectronic magnetic sensor device is known which may for example be used in a microfluidic biosensor for the detection of molecules, e.g. biological molecules, labeled with magnetic beads. The microsensor device is provided with an array of sensor units comprising wires for the generation of a magnetic field and Giant Magneto Resistances (GMR) for the detection of stray fields generated by magnetized beads. The signal of the GMRs is then indicative of the number of the beads near the sensor unit. A problem of these and similar biosensors is that the concentration of the target substance is typically very low and that the measurement signals are therefore severely corrupted by different sources of noise.

The US 6 194896 B and US 6 181 535 B disclose a method to produce a GMR element with a controlled magnetization of its pinned layer. A pulsed current is applied to the conductive layer of the GMR element, thus simultaneously generating heat and a magnetic field in the surroundings. By controlling the duty cycle of the pulses appropriately, the temperature in the pinned layer can be made to follow a temperature profile necessary for a desired annealing process.

Based on this situation it was an object of the present invention to provide means for improving the signal-to-noise ratio of a magnetic sensor device of the kind described above.

This objective is achieved by a magnetic sensor device according to claim 1, a method according to claim 2, a use according to claim8. Preferred embodiments are disclosed in the dependent claims.

A magnetic sensor device according to the present invention is primarily intended for the detection of magnetic particles in an investigation region, though this does not exclude other applications of the device. The investigation region is typically a sample chamber in a micro fluidic device in which a sample fluid to be investigated can be provided. The sensor device comprises the following components:
a) At least one magnetic field generator that is driven by an excitation current for generating a magnetic excitation field in the investigation region. The magnetic field generator may for example be realized by one or more wires on a substrate of the magnetic sensor device.
b) At least one magnetic sensor element that is driven by a sensor current for detecting magnetic reaction fields generated by particles in the investigation region that have been magnetized by the aforementioned magnetic excitation field.
c) A power supply unit for providing simultaneous pulses of sensor current and excitation current that are repeated with a sampling time interval which is longer than the pulse durations, wherein the sensor current and the excitation current are (at least approximately) zero between subsequent pulses. It should be noted that the term "pulse" shall denote here and in the following an interval of activity, i.e. current flow, wherein said activity is not necessarily constant during said interval. Thus the current may vary in magnitude and/or direction during such a "pulse". A typical value for the duration of the sampling time interval is 1 ms (corresponding to a pulse frequency of 1 kHz) with an associated pulse duration of 0.01 ms (corresponding to a duty cycle of 1 %); and in that
d) the overall thermal time constant (τ) of the space between the investigation region (5) on the one hand side and the magnetic sensor element (12) or the magnetic field generator (11, 13) on the other hand side is larger than the sampling time interval duration (Δ), preferably by a factor of 2, most preferably by a factor of 10.

The described magnetic sensor device is operated in a pulsed mode, which means that the repeated sampling of measurement data is not spread continuously over time but, for each data point, concentrated in shorter pulses. As will be shown below by a detailed analysis, the pulse duration then provides a valuable parameter which can be exploited to optimize the accuracy of the measurements.

The invention further relates to a method for the detection of magnetic particles in an investigation region which comprises the following steps:
a) Providing a magnetic field generator with an excitation current for generating a magnetic excitation field in the investigation region;
b) Providing a magnetic sensor element with a sensor current for detecting magnetic reaction fields generated by magnetic particles in reaction to the aforementioned magnetic excitation field, and
   the overall thermal time constant (τ) of the space between the investigation region (5) on the one hand side and the magnetic sensor element (12) or the magnetic field generator (11, 13) on the other hand side is provided larger than the sampling time interval duration (Δ), preferably by a factor of 2, most preferably by a factor of 10.

The method further comprises that the excitation current and the sensor current are provided as simultaneous pulses that are repeated with a sampling time interval which is longer than the pulse durations, wherein the sensor current and the excitation current are zero between subsequent pulses.

The method comprises in general form the steps that can be executed with a magnetic sensor device of the kind described above. Therefore, reference is made to the preceding description for more information on that method.

In the following, various further developments of the invention are described that apply to both a magnetic sensor device and a method of the kind described above.

In a first further development of the invention, the magnitude of the sensor current, the magnitude of the excitation current, the pulse duration, and the sampling time interval are chosen such that the signal-to-noise ratio is improved for a given maximal value of the associated power dissipation. The signal-to-noise ratio will typically improve with increasing excitation current and sensor current; these currents can however not be increased without limit because of the associated power dissipation into the sample and/or because of a limited battery lifetime. The aforementioned parameters, particularly the pulse duration, can under these conditions be exploited to

According to another preferred embodiment of the invention, the overall thermal time constant of the space between the investigation region on the one hand side and the magnetic sensor element or the magnetic field generator on the other hand side is larger than the duration of the sampling time interval, preferably by a factor of two, most preferably by a factor of ten. The mentioned "overall thermal time constant" characterizes how heat generated in the sensor element or the field generator will spread into the neighboring investigation region. Choosing the sampling time interval duration shorter than this thermal time constant has the effect that the associated pulses of dissipated heat will be smeared out on their way into the investigation region. The sample will therefore be protected from high-amplitude temperature oscillations which could be dangerous to e.g. sensitive biological substances.

While the sampling time interval duration and/or the pulse duration could be continuously adapted according to some optimization criterion, it is preferred that they remain constant over the time of a measurement.

The excitation current and/or the sensor current may be, during a pulse, a direct current or an alternating current. Alternating currents are often used to shift the resulting measurement signals in the frequency domain into regions that are advantageous for further processing.

The magnetic sensor element may particularly comprise a Hall sensor or a magneto-resistive element like a GMR (Giant Magneto Resistance), a TMR (Tunnel Magneto Resistance), or an AMR (Anisotropic Magneto Resistance) element.

The invention further relates to the use of the magnetic sensor device described above for molecular diagnostics, biological sample analysis, and/or chemical sample analysis, particularly the detection of small molecules. Molecular diagnostics may for example be accomplished with the help of magnetic beads that are directly or indirectly attached to target molecules.

These and other aspects of the invention will be apparent from and elucidated with reference to the embodiment(s) described hereinafter. These embodiments will be described by way of example with the help of the accompanying drawings in which:
Figure 1 illustrates the principle of a magnetic sensor device according to the present invention;
Figure 2 shows the pulsed power dissipation during the operation of the sensor device;
Figure 3 illustrates how a pulse modulates an AC signal through the excitation and/or sensor wire;
Figure 4 summarizes equations relating to an estimation of the signal-to-noise ratio during the application of pulsed currents.

Like reference numbers in the Figures refer to identical or similar components.

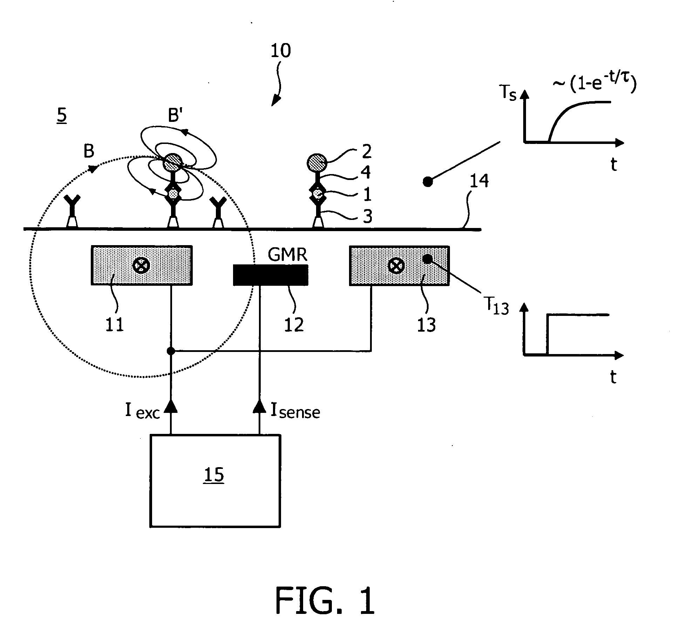

Figure 1 illustrates the principle of a single sensor 10 for the detection of superparamagnetic beads 2. A biosensor consisting of an array of (e.g. 100) such sensors 10 may be used to simultaneously measure the concentration of a large number of different target molecules 1 (e.g. protein, DNA, amino acids, drugs) in a solution (e.g. blood or saliva) that is provided in a sample chamber 5. In one possible example of a binding scheme, the so-called "sandwich assay", this is achieved by providing a binding surface 14 with first antibodies 3 to which the target molecules 1 may bind. Superparamagnetic beads 2 carrying second antibodies 4 may then attach to the bound target molecules 1. A total current I_{exc} flowing in the parallel excitation wires 11 and 13 of the sensor 10 generates a magnetic excitation field B, which then magnetizes the superparamagnetic beads 2. The reaction field B' from the superparamagnetic beads 2 introduces an in-plane magnetization component in the GMR 12 of the sensor 10, which results in a measurable resistance change that is sensed via a sensor current I_{sense.} The mentioned currents I_{exc}, Iₛₑₙₛₑ are supplied by a power supply unit 15 (wherein returning leads have been omitted in the drawing for clarity).

The signal-to-noise ratio (SNR) is an important parameter describing the performance of a magnetic sensor of the kind described above, because a high SNR either allows measuring lower target concentrations or allows measuring the same concentrations in less time. The signals that are generated by a magnetic sensor are however usually very small, which makes it hard to achieve a good SNR. Without changing the labels 2 or the geometry of the biosensor there are two ways to increase the strength of these signals:
- increase the excitation current I_{exc} through the excitation wires 11, 13 to induce a higher magnetic moment in the labels 2;
- increase the sensor current Iₛₑₙₛₑ through the sensor element 12, which leads to higher output signals for the same number of labels.

Unfortunately, either method leads to higher dissipation and typically the total power dissipation is limited because heating might cause problems for the biochemistry (for which temperatures above 37 degrees tend to lower the activity) or because of battery lifetime considerations.

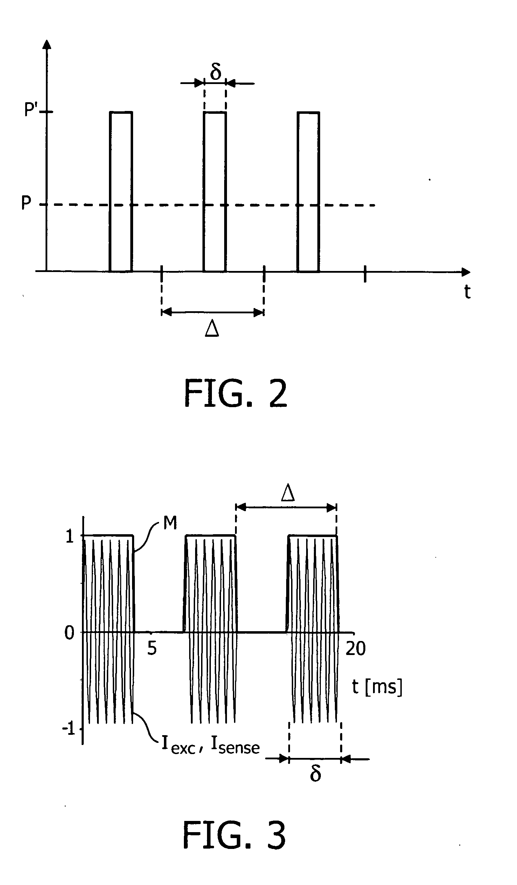

The solution for the aforementioned problems that is proposed here comprises the application of a pulsed current read-out that improves the SNR with respect to thermal noise without increasing the average power dissipation. Such a pulsed operation of the magnetic sensor device comprises the application of current pulses for the sensor current Iₛₑₙₛₑ and the excitation current I_{exc}, respectively, wherein each pulse has a duration δ and is repeated after the duration Δ of a sampling time interval. This solution is based on the insight that problems associated with power dissipation relate to the average of said dissipation. The average power dissipation can however be kept constant during a pulsed operation while the advantages of high excitation and sensor currents are nevertheless exploited. Figure 2 depicts in this respect the pulses of dissipated power which have an amplitude P' and a duration δ. The pulses are repeated with the sampling frequency 1/Δ. This leads to an average power dissipation P that is much lower than P' and that is the decisive factor with respect to heating and battery lifetime.

Figure 3 shows (with arbitrary units on the vertical axis) exemplary courses of the sensor current Iₛₑₙₛₑ and the excitation current I_{exc} that are associated with a power dissipation like that of Figure 2. The shown currents are AC currents that are modulated by pulses M, i.e. they consist of activity intervals with duration δ repeated with frequency 1/Δ and separated by periods of (approximately) zero current. The value of the sampling time Δ is strongly dependent on the frequency of the excitation current or the sensor current, respectively. If this frequency is for example 50 kHz, a pulse frequency of 1/Δ = 500 Hz to 1/Δ = 1kHz would be reasonable.

The application of high sensor and excitation currents during the pulse intervals will lead to instantaneous temperature increases around the excitation wires 11, 13 and the GMR element 12 that are higher than would be the case under continuous read-out conditions. Problems with that high temperatures can however be avoided by choosing a sufficiently high sampling frequency 1/Δ, i.e. with a sampling time interval duration Δ that is significantly shorter than the thermal time constant τ of the magnetic sensor device. Figure 1 illustrates in this respect one suited definition of the aforementioned thermal time constant τ: If a location inside an excitation wire 13 and an adjacent location inside the sample chamber 5 (e.g. the mirrored position with respect to the surface 14) are considered and if there is a jump of the temperature T₁₃ inside the wire 13, then said jump will generate at the considered location inside the sample chamber 5 a continuous increases of the sample temperature Tₛ. If a curve proportional to (1-exp(-t/τ)) is fitted to the observed increase of temperature Tₛ, the fittings parameter τ of this curve can be considered as one possible definition of the thermal constant between the considerated locations. This thermal constant can be considered by definition as the overall thermal constant for the whole magnetic sensor device 10 shown in Figure 1, or such an overall thermal constant can be derived e.g. by an averaging procedure.

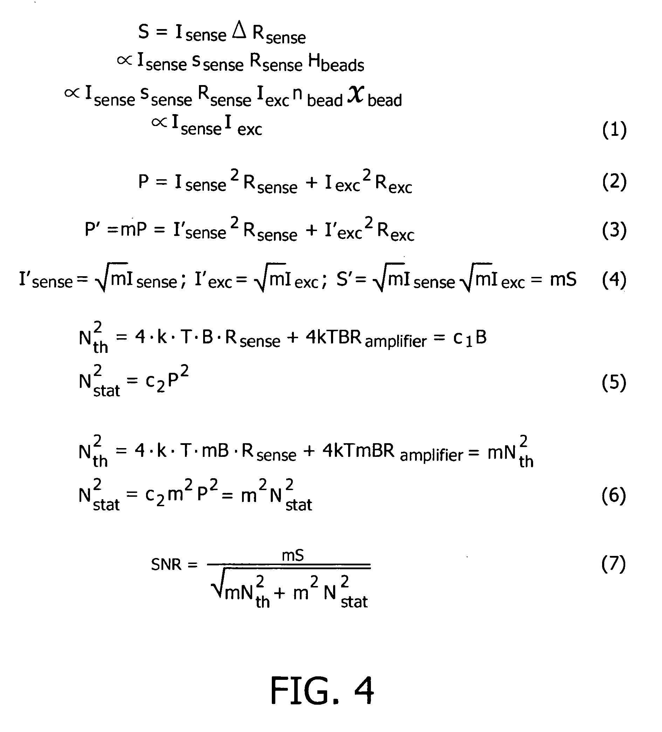

In the following, an estimation of the influence of the pulsed operation on the signal-to-noise ratio SNR will be provided with reference to the equations of Figure 4.

As expressed in equation (1), the signal S in a magnetic biosensor like that of Figure 1 is proportional to the product of the currents I_{exc} and Iₛₑₙₛₑ through the excitation element(s) and the sensing element, respectively, where Sₛₑₙₛₑ is the sensitivity of the sensing element (dR/dH)_{H=0}/Rₛₑₙₛₑ, Rₛₑₙₛₑ is the resistance of the sensing element, n_{bead} is the number of beads 2 on the sensor and χ_{bead} is the magnetic susceptibility of a single bead.

The total power P dissipated in the biosensor is the sum of the power dissipation in the sensing element 12 and the excitation element(s) 11, 13 as shown in equation (2) (where R_{exc} is the total resistance of the wires 11, 13 in their parallel configuration).

When applying a read-out pulse with a duty cycle of δ/Δ = 1m (with m being a natural number) under constant average power P, the instantaneous power consumption P' can be m times higher. This instantaneous power consumption P' is expressed in equation (3) as a function of the corresponding currents I'ₛₑₙₛₑ and I'_{exc}. If the ratio of the currents through the sensing element and the excitation element(s) is kept constant, the power increase of factor m leads to an increase of both the sensing current and the excitation current with a factor m^{1/2}, which leads according to equation (4) to an m times higher signal S'. It should be noted that the signal only increases linearly with m as long as the ratio between the currents is kept constant, which is assumed to be true in the following.

The sensor signal will always show some fluctuation due to various noise sources. These sources can be divided in
a) terms which are independent of the used power, such as the various thermal noise factors in the sensor and/or amplifier, Nₜₕ, and
b) terms which are dependent of the used power such as terms which include the arrival statistics of the beads and variations in the bead diameter, Nₛₜₐₜ.

Formula for the various fluctuation sources are given in equation (5), where B is the bandwidth of the measurement. The thermal noise sources are proportional to the square root of the bandwidth.

Under pulsed actuation conditions with a duty cycle of 1/m this bandwidth increases by a factor m (B=1/(2δ), in which δ is the measurement time which is equal to the pulse time). The statistical noise sources scale directly with the signal power and therefore this noise scales linearly with m. This results in the expressions (6) for the noise sources under pulsed read-out, which further lead to the expression (7) for the SNR. This expression shows that the thermal noise is reduced with respect to the sensor signal under pulsed read-out conditions, leading to a higher SNR. By scaling the sensor area, the balance between both types of noise sources can be shifted. Therefore, some of the reduction in the non-power dependent noise-sources can be used to reduce the power-dependent noise sources, resulting in an optimum for the overall SNR.

In summary, pulsed actuation has been presented as a manner to increase the SNR of a magnetic sensor device. The improvement is the result of a system optimization that considers both the excitation element and the sensing element. The method to improve the SNR can be used in any type of magnetic biosensor that is based on a sensing element for which the signal scales linearly with the current, such as GMR, AMR and Hall type magnetic sensing elements.

Finally it is pointed out that in the present application the term "comprising" does not exclude other elements or steps, that "a" or "an" does not exclude a plurality, and that a single processor or other unit may fulfill the functions of several means. The invention resides in each and every novel characteristic feature and each and every combination of characteristic features. Moreover, reference signs in the claims shall not be construed as limiting their scope.

## Claims

1. A magnetic sensor device (10) for the detection of magnetic particles (2) in an investigation region (5), comprising
a) a magnetic field generator (11, 13) that is driven by an excitation current (I_{exc}) for generating a magnetic excitation field (B) in the investigation region (5);
b) a magnetic sensor element (12) that is driven by a sensor current (Iₛₑₙₛₑ) for detecting magnetic reaction fields (B') generated by the magnetized particles (2),
**characterized in**
c) a power supply unit (15) for providing simultaneous pulses of sensor current (Iₛₑₙₛₑ) and excitation current (I_{exc}) that are repeated with a sampling time interval (Δ) which is longer than the pulse duration (δ), wherein the sensor current (Iₛₑₙₛₑ) and the excitation current (I_{exc}) are zero between subsequent pulses; and **in that**
d) the overall thermal time constant (τ) of the space between the investigation region (5) on the one hand side and the magnetic sensor element (12) or the magnetic field generator (11, 13) on the other hand side is larger than the sampling time interval duration (Δ), preferably by a factor of 2, most preferably by a factor of 10.

2. A method for the detection of magnetized particles (2) in an investigation region (5), comprising
a) providing a magnetic field generator (11, 13) with an excitation current (I_{exc}) for generating a magnetic excitation field (B) in the investigation region (5);
b) providing a magnetic sensor element (12) with a sensor current (Iₛₑₙₛₑ) for detecting magnetic reaction fields (B') generated by the magnetized particles (2);
wherein the excitation current (I_{exc}) and the sensor current (Iₛₑₙₛₑ) are provided as simultaneous pulses that are repeated with a sampling time interval (Δ) which is longer than the pulse duration (δ), wherein the sensor current (Iₛₑₙₛₑ) and the excitation current (I_{exc}) are zero between subsequent pulses, and
the overall thermal time constant (τ) of the space between the investigation region (5) on the one hand side and the magnetic sensor element (12) or the magnetic field generator (11, 13) on the other hand side is provided larger than the sampling time interval duration (Δ), preferably by a factor of 2, most preferably by a factor of 10.

3. The magnetic sensor device (10) according to claim 1 or the method according to claim 2,
**characterized in that** the magnitude of the sensor current (Iₛₑₙₛₑ), the magnitude of the excitation current (I_{exc}), the pulse duration (δ), and the sampling time interval (Δ) are chosen such that the signal-to-noise ratio is improved for a given upper limit (P) of the associated power dissipation.

4. The magnetic sensor device (10) according to claim 1 or the method according to claim 2,
**characterized in that** the pulse duration (δ) is less than 90%, preferably less than 50%, most preferably less than 20% of sampling time interval duration (Δ).

5. The magnetic sensor device (10) according to claim 1 or the method according to claim 2,
**characterized in that** the sampling time interval duration (Δ) and/or the pulse duration (δ) are constant over time.

6. The magnetic sensor device (10) according to claim 1 or the method according to claim 2,
**characterized in that** the excitation current (I_{exc}) and/or at the sensor current (Iₛₑₙₛₑ) are direct currents or alternating currents during a pulse.

7. The magnetic sensor device (10) according to claim 1 or the method according to claim 2,
**characterized in that** the magnetic sensor element comprises a Hall sensor or a magneto-resistive element like a GMR (12), an AMR, or a TMR element.

8. Use of the magnetic sensor device (10) according to claim 1 for molecular diagnostics, biological sample analysis, and/or chemical sample analysis, particularly the detection of small molecules.

## Patentansprüche

1. Magnetsensorvorrichtung (10) zur Detektion von magnetischen Partikeln (2) in einer Untersuchungsregion (5), wobei die Vorrichtung Folgendes umfasst:
a) einen Magnetfeldgenerator (11, 13), der durch einen Anregungsstrom (I_{exc}) angesteuert wird, um ein magnetisches Anregungsfeld (B) in der Untersuchungsregion (5) zu erzeugen;
b) ein magnetisches Sensorelement (12), das durch einen Sensorstrom (Iₛₑₙₛₑ) angesteuert wird, um magnetische Reaktionsfelder (B') zu detektieren, die durch die magnetisierten Partikel (2) erzeugt werden,
**gekennzeichnet durch**
c) eine Stromversorgungseinheit (15) zum Zuführen von gleichzeitigen Impulsen von Sensorstrom (Iₛₑₙₛₑ) und Anregungsstrom (I_{exc}), die mit einem Abtastzeitintervall (Δ) wiederholt werden, welches länger ist als die Impulsdauer (δ), wobei der Sensorstrom (Iₛₑₙₛₑ) und der Anregungsstrom (I_{exc}) zwischen aufeinanderfolgenden Impulsen Null sind; und **dadurch**, dass
d) die thermische Gesamtzeitkonstante (τ) des Raums zwischen der Untersuchungsregion (5) auf der einen Seite und dem magnetischen Sensorelement (12) oder dem Magnetfeldgenerator (11, 13) auf der anderen Seite größer ist als die Abtastzeitintervalldauer (Δ), vorzugsweise um einen Faktor von 2, möglichst jedoch um einen Faktor von 10.

2. Verfahren zur Detektion von magnetisierten Partikeln (2) in einer Untersuchungsregion (5), wobei das Verfahren Folgendes umfasst:
a) Schaffen eines Magnetfeldgenerators (11, 13) mit einem Anregungsstrom (I_{exc}) zum Erzeugen eines magnetischen Anregungsfelds (B) in der Untersuchungsregion (5);
b) Schaffen eines magnetisches Sensorelements (12) mit einem Sensorstrom (Iₛₑₙₛₑ) zum Detektieren magnetischer Reaktionsfelder (B'), die durch die magnetisierten Partikel (2) erzeugt werden;
wobei der Anregungsstrom (I_{exc}) und der Sensorstrom (Iₛₑₙₛₑ) als gleichzeitige Impulse bereitgestellt werden, die mit einem Abtastzeitintervall (Δ) wiederholt werden, welches länger ist als die Impulsdauer (δ), wobei der Sensorstrom (Iₛₑₙₛₑ) und der Anregungsstrom (I_{exc}) zwischen aufeinanderfolgenden Impulsen Null sind; und
die thermische Gesamtzeitkonstante (τ) des Raums zwischen der Untersuchungsregion (5) auf der einen Seite und dem magnetischen Sensorelement (12) oder dem Magnetfeldgenerator (11, 13) auf der anderen Seite größer ist als die Abtastzeitintervalldauer (Δ), vorzugsweise um einen Faktor von 2, möglichst jedoch um einen Faktor von 10.

3. Magnetsensorvorrichtung (10) nach Anspruch 1 oder Verfahren nach Anspruch 2,
**dadurch gekennzeichnet, dass** die Größe des Sensorstroms (Iₛₑₙₛₑ), die Größe des Anregungsstroms (I_{exc}), die Impulsdauer (δ) und das Abtastzeitintervall (Δ) so gewählt werden, dass das Signal-Rausch-Verhältnis für eine gegebene Obergrenze (P) der zugehörigen Verlustleistung verbessert wird.

4. Magnetsensorvorrichtung (10) nach Anspruch 1 oder Verfahren nach Anspruch 2,
**dadurch gekennzeichnet, dass** die Impulsdauer (δ) weniger als 90%, vorzugsweise weniger als 50%, möglichst jedoch weniger als 20% der Abtastzeitintervalldauer (Δ) beträgt.

5. Magnetsensorvorrichtung (10) nach Anspruch 1 oder Verfahren nach Anspruch 2,
**dadurch gekennzeichnet, dass** die Abtastzeitintervalldauer (Δ) und/oder die Impulsdauer (δ) über die Zeit konstant sind.

6. Magnetsensorvorrichtung (10) nach Anspruch 1 oder Verfahren nach Anspruch 2,
**dadurch gekennzeichnet, dass** der Anregungsstrom (I_{exc}) und/oder der Sensorstrom (Iₛₑₙₛₑ) Gleichströme oder Wechselströme während eines Impulses sind.

7. Magnetsensorvorrichtung (10) nach Anspruch 1 oder Verfahren nach Anspruch 2,
**dadurch gekennzeichnet, dass** das Magnetsensorelement einen Hall-Sensor oder ein magnetoresistives Element wie ein GMR- (12), ein AMR- oder ein TMR-Element umfasst.

8. Nutzung der Magnetsensorvorrichtung (10) nach Anspruch 1 für Molekulardiagnostik, biologische Probenanalyse und/oder chemische Probenanalyse, insbesondere für die Detektion kleiner Moleküle.

## Revendications

1. Dispositif de capteur magnétique (10) pour la détection de particules magnétiques (2) dans une région d'investigation (5), comprenant
a) un générateur de champ magnétique (11, 13) qui est entraîné par un courant d'excitation (I_{exc}) pour générer un champ d'excitation magnétique (B) dans la région d'investigation (5) ;
b) un élément de capteur magnétique (12) qui est entraîné par un courant de capteur (I_{capteur}) pour détecter des champs de réaction magnétiques (B') générés par les particules magnétisées (2),
**caractérisé en ce que**
c) une unité d'alimentation (15) pour fournir des impulsions simultanées de courant de capteur (I_{capteur}) et courant d'excitation (I_{exc}) qui sont répétées avec un intervalle de temps d'échantillonnage (Δ) qui est plus long que la durée d'impulsion (δ), où le courant de capteur (I_{capteur}) et le courant d'excitation (I_{exc}) sont nuls entre des impulsions ultérieures ; et **en ce que**
d) la constante de temps thermique globale (τ) de l'espace entre la région d'investigation (5) d'une part et l'élément de capteur magnétique (12) ou le générateur de champ magnétique (11, 13) d'autre part est plus grande que la durée de l'intervalle de temps d'échantillonnage (Δ), de préférence par un facteur de 2, de manière préférée entre toutes d'un facteur de 10.

2. Procédé de détection de particules magnétisées (2) dans une région d'investigation (5), comprenant les étapes consistant à
a) fournir un générateur de champ magnétique (11, 13) avec un courant d'excitation (I_{exc}) pour générer un champ d'excitation magnétique (B) dans la région d'investigation (5) ;
b) fournir un élément de capteur magnétique (12) avec un courant de capteur (I_{capteur}) pour détecter des champs de réaction magnétiques (B') générés par les particules magnétisées (2) ;
où le courant d'excitation (I_{exc}) et le courant de capteur (I_{capteur}) sont fournis sous forme d'impulsions simultanées qui sont répétées avec un intervalle de temps d'échantillonnage (Δ) qui est plus long que la durée d'impulsion (δ), où le courant de capteur (I_{capteur}) et le courant d'excitation (I_{exc}) sont nuls entre des impulsions ultérieures, et
la constante de temps thermique globale (τ) de l'espace entre la région d'investigation (5) d'une part et l'élément de capteur magnétique (12) ou le générateur de champ magnétique (11, 13) d'autre part est plus grande que la durée de l'intervalle de temps d'échantillonnage (Δ), de préférence par un facteur de 2, de manière préférée entre toutes d'un facteur de 10.

3. Dispositif de capteur magnétique (10) selon la revendication 1 ou procédé selon la revendication 2,
**caractérisé en ce que** la grandeur du courant de capteur (I_{capteur}), la grandeur du courant d'excitation (I_{exc}), la durée d'impulsion (δ) et l'intervalle de temps d'échantillonnage (Δ) sont choisis de telle sorte que le rapport signal sur bruit est amélioré pour une limite supérieure donnée (P) de la dissipation de puissance associée.

4. Dispositif de capteur magnétique (10) selon la revendication 1 ou procédé selon la revendication 2,
**caractérisé en ce que** la durée d'impulsion (δ) est inférieure à 90 %, de préférence inférieure à 50 %, de manière préférée entre toutes inférieure à 20 % de la durée d'intervalle de temps d'échantillonnage (Δ).

5. Dispositif de capteur magnétique (10) selon la revendication 1 ou procédé selon la revendication 2,
**caractérisé en ce que** la durée d'intervalle de temps d'échantillonnage (Δ) et/ou durée d'impulsion (δ) sont constantes au court du temps.

6. Dispositif de capteur magnétique (10) selon la revendication 1 ou procédé selon la revendication 2,
**caractérisé en ce que** le courant d'excitation (I_{exc}) et/ou le courant de capteur (I_{capteur}) sont des courants continus ou des courants alternatifs pendant une impulsion.

7. Dispositif de capteur magnétique (10) selon la revendication 1 ou procédé selon la revendication 2,
**caractérisé en ce que** l'élément de capteur magnétique comprend un capteur de Hall ou un élément magnéto-résistif comme un élément GMR (12), AMR ou TMR.

8. Utilisation du dispositif de capteur magnétique (10) selon la revendication 1, pour le diagnostic moléculaire, l'analyse d'échantillons biologiques et/ou l'analyse d'échantillons chimiques, en particulier la détection de petites molécules.
